# EUROPÄISCHE PATENTANMELDUNG

(11) **EP 0 526 817 A1**
(43) Veröffentlichungstag der Anmeldung: **10.02.1993**
(21) Anmeldenummer: 92112709.8
(22) Anmeldetag: 24.07.1992
(51) Int. Cl.: G01T 1/24, G01T 1/29, H01L 27/14

(54) **Strahlungsdetektor**

(30) Priorität: 05.08.1991 DE 4125929
(71) Anmelder: SIEMENS AKTIENGESELLSCHAFT, D-80333 München (DE)
(72) Erfinder: Birkle, Siegfried, Dr., W-8552 Höchstadt/Aisch (DE); Kammermaier, Johann, Dr., verstorben (DE); Rittmayer, Gerhard, Dr., W-8520 Erlangen (DE)

(57) **Zusammenfassung**

Der in Dünnschichttechnik aufgebaute Strahlungsdetektor ist gekennzeichnet durch zwei plane Metallelektroden, von denen wenigstens eine aus einem Metall mit einer Ordnungszahl Z > 70 besteht, und eine zwischen den beiden Metallelektroden angeordnete Isolierschicht aus plasmaabgeschiedenem amorphem wasserstoffhaltigem Kohlenstoff (a-C:H) mit einem optischen Bandabstand ≧ 0,9 eV, die zu der aus einem Metall mit Z > 70 bestehenden Elektrode eine defektarme Grenzschicht mit ohmschen Kontakten bildet.

## Beschreibung

Die Erfindung betrifft einen Strahlungsdetektor in Dünnschichttechnik sowie ein Verfahren zu dessen Herstellung.

Zur elektronischen Erfassung und Verarbeitung von mit ionisierender Strahlung, wie Röntgenstrahlen, erzeugten Signalen für bildgebende Systeme in der Medizintechnik, beispielsweise bei einfachen Schirmbildern oder bei der Röntgen-Computertomographie, und bei der Materialprüfung werden Detektoren in Form kleiner Flächenelemente benötigt, die die auftreffenden Strahlungsquanten bzw. Teilchen elektrisch quantitativ zu erfassen vermögen. An derartige Sensorelemente werden folgende Anforderungen gestellt:
- Die durch die Strahlung in der sensoraktiven Komponente freigesetzten Ladungen müssen mit Hilfe eines elektrischen Feldes soweit abgesaugt werden können, daß eine direkte Erfassung durch eine Auswerteelektronik möglich ist.
- Hohe Quantenausbeute des sensoraktiven Materials, um eine hohe Meßempfindlichkeit für die betreffende Strahlung zu erreichen und damit deren Dosis auf ein physiologisch unschädliches Maß reduzieren zu können.
- Gleichbleibende Meßempfindlichkeit, um keine Nacheichungen durchführen zu müssen.
- Proportionalität zwischen Strahlungsintensität und Meßsignal.
- Auslegung der Sensoren in Form von Mikrostrukturen (um-Bereich) in Dünnschichttechnik, um eine hohe örtliche Auflösung und hohe Konturenschärfe des Röntgenbildes zu ermöglichen.
- Kurze Ansprech- und Abklingzeit bei Änderung der Bestrahlung.
- Multiplexbarkeit von Sensorzeilensystemen nach bekannten Techniken.
- Mechanische Stabilität, d.h. Verschleißfestigkeit, und chemische Stabilität des Sensoraufbaus sowie Feuchteunempfindlichkeit.
- Keine Schädigung durch auftreffende Strahlung.

Zur Aufzeichnung von mit Röntgen- oder Korpuskularstrahlen erzeugten Bildern auf dem Gebiet der Medizin- und Materialprüftechnik werden derzeit noch überwiegend photographische Verfahren eingesetzt. Damit können aber lediglich elektronisch nicht bzw. nur aufwendig verarbeitbare Bilder mit einer aufgrund der Schwärzungskurve ungleichmäßigen Meßempfindlichkeit erhalten werden. Von Nachteil ist ferner der relativ hohe Zeitaufwand zur Aufbereitung des belichteten photographischen Materials, das darüber hinaus nur zum einmaligen Gebrauch geeignet ist.

Um elektronisch simultan verarbeitbare Röntgenbilder zu erhalten, werden als Strahlungsdetektoren seit längerem Xenon-lonisationskammern, Germanium-PIN-Dioden und mit Photosensoren kombinierte Festkörperszintillatoren, insbesondere auf der Basis von CsJ, GdO und Gd₂0₂S, eingesetzt. Bekannt sind aber auch in Dünnschichttechnik aus a-Si- bzw. a-Si:H-Schichten mit Metallelektroden aufgebaute y-Detektoren, wie Ta/a-Si/Mo (siehe dazu: "IEEE Trans. Nucl. Sci.", Vol. 36 (1989), Seiten 1347 bis 1352, und "J. Non-Cryst. Solids", Vol. 115 (1989), Seiten 174 bis 176). Bei den Szintillationsdetektoren wird die Röntgenstrahlung zunächst in sichtbares Licht und dann - mittels Photosensoren - in elektrische Signale umgewandelt. Bei den Sensoren mit Xenon-lonisationskammer und Germanium-PIN-Dioden erzeugt die absorbierte Röntgenstrahlung direkt, bei den aus Metall/a-Si bzw. a-Si:H aufgebauten Sensoren indirekt - über die aus den Metallelektroden freigesetzten Elektronen - Ladungspaare (Elektron-lon bzw. Elektron-Loch), die elektrisch erfaßt werden.

Aus der EP-PS 0 239 808 ist eine Festkörper-Strahlungsdetektorvorrichtung bekannt, welche Detektorzellenteile aufweist, die gestapelt sind, um einfallende Strahlen im wesentlichen senkrecht zu empfangen. Die Detektorzellenteile umfassen dabei eine Vielzahl von Halbleiterschichten und eine Vielzahl von Metallschichten, die abwechselnd zwischen benachbarten Halbleiterschichten vorgesehen sind, so daß die Detektorzellenteile durch zwei benachbarte Metallschichten gebildet sind, welche eine Halbleiterschicht einschließen. Durch Wechselwirkung zwischen den Metallschichten und der einfallenden Strahlung werden freie Energieteilchen erzeugt, die in die Halbleiterschichten eintreten und diese so anregen, daß darin Elektron-Loch-Paare erzeugt werden. Die Elektron-Loch-Paare werden gesammelt, um Ladungsträger zum Erzeugen eines elektrischen Strahlungsmeßsignals zu erhalten. Wesentlich ist dabei, daß die Metallschichten aus Metallen mit einer Ordnungszahl ("atomic number") von 30 oder mehr bestehen und daß die Dicke der Metallschichten so festgesetzt ist, daß sie kleiner ist als die mittlere Reichweite (im Metall) der Teilchen, die durch die Wechselwirkung der zu erfassenden Strahlung mit dem Metall im wesentlichen erzeugt werden.

Bei der bekannten Strahlungsdetektorvorrichtung beinhalten die Metallschichten eine erste Metallschicht, um eine Schottky-Barriere zwischen ihr und der Halbleiterschicht zu bilden, sowie eine zweite Metallschicht, die in ohmschem Kontakt mit der Halbleiterschicht steht; diese ersten und zweiten Metallschichten sind abwechselnd zwischen den benachbarten Halbleiterschichten angeordnet. Als Metalle sind Molybdän, Tantal und Gold genannt. Die Halbleiterschichten bestehen im allgemeinen aus amorphem Silicium; als amorphe Halbleiter sind daneben noch Germanium, Selen und Gallium aufgeführt.

Nachteilig wirkt sich bei den bekannten Röntgen- bzw. y-Detektoren folgendes aus:
- Bei Xenon-lonisationskammern ist eine aufwendige Technik (hoher Gasdruck, Absorptionslänge bis zu 6 cm) erforderlich, außerdem sind die Abklingzeiten relativ lang und die Ortsauflösung ist gering.
- Bei Szintillationsdetektoren erfolgt ein Nachleuchten bis zu einigen Millisekunden, wodurch die zeitliche Auflösung begrenzt ist.
- Bei Germanium-PIN-Dioden ist eine Kühlung zur Unterdrückung des Dunkelstromes erforderlich, außerdem ist die Langzeitstabilität gering und es ist eine laterale Unterteilung zur Vermeidung des Übersprechens notwendig.
- Bei a-Si- bzw. a-Si:H-Dünnschichten ist ein Feuchteschutz erforderlich.

Aufgabe der Erfindung ist es, einen Strahlungsdetektor in Dünnschichttechnik derart auszugestalten, daß er zur elektronischen Erfassung von Röntgen- und Korpuskularstrahlen geeignet ist und dabei das gesamte Anforderungsprofil erfüllt, das an derartige Detektoren gestellt wird.

Dies wird erfindungsgemäß durch einen Strahlungsdetektor erreicht, der gekennzeichnet ist durch zwei plane Metallelektroden, von denen wenigstens eine aus einem Metall mit einer Ordnungszahl Z > 70 besteht, und eine zwischen den beiden Metallelektroden angeordnete Isolierschicht aus plasmaabgeschiedenem amorphem wasserstoffhaltigem Kohlenstoff (a-C:H) mit einem optischen Bandabstand 0,9 eV, die zu der aus einem Metall mit einer Ordnungszahl Z > 70 bestehenden Metallelektrode eine defektarme Grenzschicht mit ohmschen Kontakten bildet.

Beim Strahlungsdetektor nach der Erfindung sind folgende vier Merkmale wesentlich:
1. Metallelektrode aus einem Metall mit Z > 70: Aufgrund der hohen Ordnungszahl weisen derartige Metalle schon in Schichtdicken von einigen Mikrometern, bei denen eine Reabsorption der durch die Strahlung freigesetzten Elektronen noch keine Rolle spielt, eine zur meßbaren Erfassung der Strahlung ausreichende Absorption auf.
2. Isolierschicht aus amorphem wserstoffhaltigem Kohlenstoff:
   a-C:H ist eine neuartige röntgenamorphe Kohlenstoffmodifikation, in der die C-Atome teils tetraedrisch (_{S}p³), teils trigonal (sp²) - unter Einbindung eines unterstöchiometrischen H-Anteils - hybridisiert sind (siehe beispielsweise: "IDR - Industrie Diamanten Rundschau", Bd. 18 (1984), Seiten 249 bis 253). Dieses Material hat eine bemerkenswert hohe mechanische und chemische stabilität und es stellt zudem eine ausgezeichnete Feuchtebarriere dar (siehe dazu: Herbert Reichl (Editor) "Micro System Technologies 90", Springer-Verlag Berlin Heidelberg 1990, Seiten 307 bis 312). Für den erfindungsgemäßen Strahlungsdetektor besteht ein besonderer Vorteil darin, daß a-C:H-Schichten elektrisch isolierend sind, a-C:H aber trotzdem eine ausreichende elektronische Leitfähigkeit besitzt. Darüber hinaus können die intrinsischen optischen und elektrischen Eigenschaften (optischer Bandabstand, Dielektrizitätszahl und Isolationswiderstand) von a-C:H - durch die Bedingungen bei der Plasmaabscheidung - in einem weiten Bereich gesteuert und speziellen Anforderungen angepaßt werden. Bemerkenswert ist auch ein ausgeprägter Avalanche-Effekt, indem die aus Metallelektroden in a-C:H übertretenden bzw. injizierten Elektronen durch anliegende hohe elektrische Felder soweit energetisch beschleunigt werden können, daß durch reversible Elektronenlawinenbildung eine hohe Meßstromverstärkung erfolgt. Dieser Effekt tritt in a-C:H bei Feldstärken um 10⁵ V/cm auf. Im Gegensatz dazu zeigt sich bei a-Si:H bei Feldstärken bis zu 2.10⁵ V/cm noch kein Avalanche-Effekt.
3. Defektarme Grenzschicht:

Beim Strahlungsdetektor nach der Erfindung besteht zwischen der a-C:H-Schicht und den angrenzenden y-Fabsorbierenden Metallelektroden eine stabile stoffschlüssige Bindung. Deshalb entstehen hierbei nur verhältnismäßig wenig elektronische Defekte bzw. sogenannte Elektronenfallen. Dies ist ein grundlegender Unterschied zu mit a-Si bzw. a-Si:H aufgebauten Detektoren. Derartige Detektoren weisen nämlich - herstellungsbedingt (Abscheidung mittels eines CVD-Prozesses, d.h. mit verhältnismäßig hoher thermischer Energie, aber niedriger Teilchenenergie) - eine größere Anzahl von elektronischen Defekten in der Grenzschicht Halbleiter/Metall auf, durch die ein Teil der durch y-Absorption in der Metallelektrode freigesetzten Elektronen festgehalten wird. Dadurch ergibt sich eine deutlich niedrigere Ladungsausbeute (- 0,12 nA/cm²) als beim erfindungsgemäß aus a-C:H aufgebauten Strahlungsdetektor (> 0,28 nA/cm²), der einen freien Durchtritt der Elektronen durch die Grenzschicht Isolierstoff/Metall gestattet. 4. Ohmscher Kontakt:

Im Gegensatz zu der bekannten Strahlungsdetektorvorrichtung (siehe EP-PS 0 239 808), wo zwischen einer Elektrode und dem Halbleitermaterial aus a-Si - aufgrund eines Schottky-Kontaktes - eine Schottky-Barriere besteht, bildet beim erfindungsgemäßen Strahlungsdetektor die Isolierschicht aus a-C:H mit den angrenzenden Metallelektroden einen ohmschen Kontakt. Dies bedeutet, daß die Austrittsarbeit für die Elektronen im Metall und im a-C:H im wesentlichen gleich ist, d.h. im a-C:H bildet sich - im Gegensatz zu einem Schottky-Kontakt - im unbestrahlten Zustand keine an Ladungsträgern verarmte Randschicht und keine Sperrschicht aus. Beim Vorhandensein von zwei Elektroden mit ohmschem Kontakt wird das Strommeßsignal polarisationsunabhängig, so daß zur Erfassung und Verstärkung des Signals auch eine Wechselstromtechnik verwendet werden kann, was in mancherlei Hinsicht vorteilhaft ist.

Beim Strahlungsdetektor nach der Erfindung dient die a-C:H-Schicht als Trennschicht zwischen den beiden Metallelektroden und nicht als Ladungsträger erzeugendes Medium. Diese Schicht, die durch Plasmaabscheidung hergestellt wird und einen optischen Bandabstand ≧ 0,9 eV besitzt, vorteilhaft 1,2 eV, weist vorzugsweise eine Dicke von 0,3 bis 5 um auf.

Eine oder beide Elektroden des erfindungsgemäßen Strahlungsdetektors bestehen aus einem Metall mit einer Ordnungszahl Z > 70. Im allgemeinen dient dazu ein Schwermetall in Form von Tantal (Z = 73), Wolfram (Z = 74), Rhenium (Z = 75), Osmium (Z = 76), Iridium (Z = 77), Platin (Z = 78) oder Gold (Z = 79). Vorzugsweise besteht eine der beiden Elektroden aus einem der genannten Schwermetalle, und die andere Elektrode besteht aus Aluminium (Z = 13). Neben Aluminium kommen für diese Elektrode beispielsweise auch Nickel (Z = 28) und Kupfer (Z = 29) in Betracht. Die Schwermetallelektroden weisen vorzugsweise eine Dicke von 1 bis 5 um auf; diese Elektroden können prinzipiell aber auch in Form von Metallfolien vorliegen. Die Elektroden aus Aluminium usw. besitzen im allgemeinen eine Dicke 1 1 um. Eine der beiden Metallelektroden kann im übrigen auch auf einem Trägermaterial angeordnet sein, das vorzugsweise ein Wafer, ein Glassubstrat, beispielsweise aus Quarzglas, oder eine Folie aus Kunststoff ist.

Der erfindungsgemäße Strahlungsdetektor kann vorteilhaft nach der Mehrlagentechnik aufgebaut sein. Dabei sind dann wenigstens zwei Detektormodule bzw. -bausteine aus je einem Paar Metallelektroden und einer Isolierschicht aus a-C:H hinter-oder übereinander angeordnet, wobei die einzelnen Detektormodule jeweils durch eine entsprechende Isolierschicht aus a-C:H voneinander getrennt sind, d.h. aus plasmaabgeschiedenem a-C:H mit einem optischen Bandabstand ≧ 0,9 eV.

Der Strahlungsdetektor kann erfindungsgemäß in der Weise hergestellt werden, daß Metallelektroden auf eine a-C:H-Schicht aufgedampft oder aufgesputtert werden. Vorzugsweise wird aber in der Weise vorgegangen, daß a-C:H auf einer Schwermetallelektrode (Z > 70) abgeschieden wird und auf die a-C:H-Schicht dann die zweite Metallelektrode aufgebracht wird. In jedem Fall müssen die beiden Elektroden dann anschließend noch kontaktiert werden.

Die Herstellung von a-C:H selbst erfolgt durch eine Hochfrequenz-Niederdruck-Plasmaabscheidung gasförmiger Kohlenwasserstoffe, und zwar zunächst bei einer Self-bias-Spannung von -800 V und dann bei einer Self-bias-Spannung von ≧ - 400 V. Der amorphe wasserstoffhaltige Kohlenstoff wird dabei auf einem Substrat abgeschieden.

Bei der genannten Art der Plasmaabscheidung von a-C:H, bei der es sich um eine durch einen Self-bias-Effekt gestützte lonenabscheidung handelt, weisen die auf das Substrat auftreffenden Teilchen, d.h. die CₓH_{y}-lonen, eine sehr hohe kinetische Energie auf (bis zu 100 eV). Diese hohe Energie bewirkt die Ausbildung diamantartiger Bindungen in der entstehenden a-C:H-Schicht und führt primär zur Bildung sehr dünner Grenzschichten (Dicke: bis zu 50 nm) aus Carbid, die chemisch sehr stabil sind. Wird a-C:H direkt auf einer Schwermetallelektrode abgeschieden, so bewirken diese Carbidschichten eine stoffschlüssige Bindung der a-C:H-Schicht an die Metallelektrode und damit eine stabile Haftung. Außerdem entstehen dabei verhältnismäßig wenig elektronische Defekte.

Zur Ausbildung von defektarmen Grenzschichten der genannten Art erfolgt die Plasmaabscheidung zunächst bei einer Selfbias-Spannung von ≦ - 800 V, d.h. ≧ |800 V|; die kinetische Energie der Teilchen beträgt hierbei 50 eV. Derartige Grenzschichten besitzen einen optischen Bandabstand von ≧ 0,9 eV. Anschließend erfolgt die Herstellung der eigentlichen a-C:H-Isolierschicht, wobei die Plasmaabscheidung bei einer Selfbias-Spannung von -400 V erfolgt, d.h. < 1400 V|. Die kinetische Energie der Teilchen beträgt in diesem Fall 30 eV. Die dabei gebildete a-C:H-Schicht weist einen optischen Bandabstand von 1,2 eV auf, der spezifische elektrische Widerstand der Schicht beträgt > 1012Q.cm.

Bei der beschriebenen Vorgehensweise bilden sich zwischen der a-C:H-Schicht und der Schwermetallelektrode Heterostrukturen aus, so daß die durch die absorbierte Strahlung in der Schwermetallelektrode freigesetzten Elektronen weitgehend verlustfrei in die a-C:H-Schicht, die gute Ladungstransporteigenschaften besitzt, gelangen können. Von entscheidender Bedeutung ist dabei, daß die Heteroübergänge - durch die Wahl geeigneter Plasmaparameter bei der a-C:H-Abscheidung - sich mit einer so niedrigen elektronischen Zustandsdichte herstellen lassen, daß Rekombinationen der freigesetzten Elektronen weniger ins Gewicht fallen als beispielsweise bei a-Si:H/Schwermetall-Grenzflächen. Infolge der gegenüber Si (Z = 14) niedrigeren Ordnungszahl von Kohlenstoff (Z = 6) absorbiert a-C:H Röntgenstrahlen schwächer als a-Si:H, was zur Erzielung einer Proportionalität zwischen der zu messenden Strahlendosis und dem Meßsignal und für die Unempfindlichkeit gegenüber Veränderungen durch auftreffende Strahlung wichtig ist.

Mit einem aus einer 3 um dicken Wolframelektrode, einer 3 um dicken a-C:H-Schicht und einer 0,1 um dicken Aluminiumelektrode aufgebauten Strahlungsdetektor läßt sich mit einer 50 kV-Röntgenstrahlung bei biasfreier Messung eine Quantenausbeute von 60 erreichen. Dies entspricht den Ergebnissen bei y-Detektoren, die in Dünnschichttechnik aus 3 um dicken a-Si:H-Schichten und 0,5 µm dicken Tantal- bzw. Molybdänelektroden aufgebaut sind. Aufgrund eines - bei gleicher Isolation - durch eine niedrigere Dielektrizitätszahl (DK bei a-C:H 4, bei a-Si:H - 11) möglichen niedrigeren RC-Wertes ergibt sich bei einem a-C:H-Element jedoch eine kürzere Abklingzeit als bei einem entsprechenden Aufbau mit a-Si:H. Außerdem läßt sich a-C:H pinholefrei und - aufgrund des amorphen Charakters - sehr homogen abscheiden und ist photolithographisch mit Hilfe von 0₂-Ätzplasmen sehr fein strukturierbar. Deshalb kann der erfindungsgemäße Strahlungsdetektor mit sehr kleinen Abmessungen (µm-Bereich) hergestellt werden.

Bei der a-C:H-Abscheidung dient zur Plasmaanregung, die mittels Hochfrequenz (HF) erfolgt, vorzugsweise Radiofrequenz (RF), d.h. der Bereich zwischen 0,1 und 100 MHz, beispielsweise eine Frequenz von 13,56 MHz. Die Abscheidung erfolgt im allgemeinen in einer Reaktionskammer (Reaktor), der das Reaktionsgas, d.h. der gasförmige Kohlenwasserstoff, zugeführt wird. Die Reaktionskammer weist zwei Elektroden unterschiedlicher Größe auf, von denen die größere die Masseelektrode (Anode) und die kleinere die HF-Elektrode (Kathode) ist. Das Flächenverhältnis von Anode zu Kathode beträgt im allgemeinen 2:1.

Als gasförmige Kohlenwasserstoffe werden dabei vorteilhaft Alkane eingesetzt, d.h. gesättigte aliphatische Kohlenwasserstoffe, wie Methan, Ethan und Propan, vorzugsweise Methan. Daneben können aber auch Alkene, d.h. ungesättigte aliphatische Kohlenwasserstoffe, wie Ethen und Propen, verwendet werden, sowie Acetylen, Cycloalkane, d.h. gesättigte cyclische Kohlenwasserstoffe, wie Cyclohexan, und - im dampfförmigen Zustand - aromatische Kohlenwasserstoffe in Form von Benzol und Benzolderivaten. Die Kohlenwasserstoffe der genannten Art können dabei einzeln oder im Gemisch zum Einsatz gelangen.

Der erfindungsgemäße Strahlungsdetektor besteht im einfachsten Fall aus einem Trägermaterial, beispielsweise einem Wafer, auf dem eine Grundelektrode aus Schwermetall angeordnet ist. Zwischen dieser Grundelektrode und einer Deckelektrode, die aus Schwermetall oder beispielsweise aus Aluminum bestehen kann, ist die a-C:H-Isolierschicht angeordnet. Die Grundelektrode und die Deckelektrode, die beim Betrieb des Detektors der Strahlung ausgesetzt ist, werden mit Kontaktanschlüssen versehen. Bei einem Mehrlagenaufbau folgt auf die Deckelektrode eine a-C:H-Schicht, dann eine Grundelektrode, eine a-C:H-Schicht und eine Deckelektrode usw.. Die Elektroden können dabei sowohl parallel als auch in Serie geschaltet werden.

Anhand von Ausführungsbeispielen soll die Erfindung noch näher erläutert werden.

Auf einen siliciumwafer, der mit einer 3 um dicken Schicht aus Wolfram als Grundelektrode versehen ist, wird eine 3 um dicke Schicht aus a-C:H abgeschieden und darauf eine 0,1 um dicke Deckelektrode aus Aluminium aufgebracht. Die Metallelektroden werden im allgemeinen nach physikalischen Methoden hergestellt, vorzugsweise durch Sputtern; insbesondere bei Aluminium kann beispielsweise aber auch ein Aufdampfprozeß angewendet werden. Die Herstellung der a-C:H-Schicht erfolgt durch Plasmaabscheidung mittels RF-Anregung. Als gasförmige Kohlenwasserstoffe dienen insbesondere Methan, Ethan, Ethylen, Acetylen und Benzol, gegebenenfalls mit einer Beimischung von Wasserstoff. Das Reaktionsgas, beispielsweise Methan, wird seitlich in eine zylindrische Reaktionskammer eingeleitet und gelangt in das sich zwischen zwei ungleichen Elektroden (Flächenverhältnis 2) ausbildende Plasma. Aufgrund der ungleichen Elektroden entsteht bei der RF-Anregung (Frequenz: 13,56 MHz) eine sich der HF-Spannung überlagernde DC-Self-bias-Spannung, wobei die kleinere Elektrode, die das zu beschichtende Substrat trägt, zur Kathode wird.

Zur Ausbildung einer defektarmen Carbid-Grenzschicht (Dicke 50 nm) mit einem optischen Bandabstand von 0,9 eV wird zunächst ein Gasdruck von ca. 20 Pa eingestellt und mit einer HF-Leistungsdichte von 2,5 W/cm² (auf der Kathode) eine Selfbias-Spannung von -900 V erzeugt. Anschließend wird - ohne Zwischenbelüftung - bei einem Gasdruck von ca. 100 Pa und einer Self- bias-Spannung von -400 V mit einer HF-Leistungsdichte von 1 W/cm² (auf der Kathode) innerhalb von ca. 18 min eine 3 um dicke a-C:H-Schicht mit einem optischen Bandabstand von 1,2 eV, einem spezifischen elektrischen Widerstand von ca. 4.10¹² Ω.cm und einem H₂0-Permeationskoeffizienten von < ₅.₁₀-¹³ m²/s abgeschieden.

Die Strom-Spannungscharakteristik eines derart aufgebauten Strahlungsdetektors - ohne Bestrahlung und bei einer Beaufschlagung mit einer 50 KV-Röntgenstrahlung bei einer Dosisleistung von 0,2 R/s - ergibt folgendes. Der Verlauf des Dunkelstromes zeigt innerhalb eines Spannungsbereiches bis zu ca. ± 5 V eine symmetrische, d.h. ohmsche Charakteristik, welche einen barrierefreien Übergang zwischen der a-C:H-Schicht und den Metallelektroden erkennen läßt. Bei Röntgenbestrahlung ergibt sich eine I-U-Kennlinie, die sich aus der Wirkung einer durch die Ladungsdoppelschicht in der Grenzfläche W/a-C:H - infolge der y-Strahlung - erzeugten EMK und dem Effekt der angelegten Klemmenspannung zusammensetzt.

Als Maß für die primäre Signalempfindlichkeit bzw. die Quantenausbeute dient der bei biasfreier Messung (U = 0) resultierende Strom, bezogen auf den Photonenfluß der angewandten Röntgenstrahlung. Daraus folgt für die Quantenausbeute ein Wert von 60, der die Werte für entsprechende Detektorsysteme mit a-Si:H-Dünnschichten zumindest erreicht. Aufgrund der niedrigeren Dielektrizitätszahl von a-C:H (gegenüber derjenigen von a-Si:H) ergibt sich - bei gleichem Isolationswiderstand - aber ein kleinerer RC-Wert und damit ein schnelleres Abklingen. Mit Hilfe eines Mehrlagenaufbaus und unter Ausnutzung des bei a-C:H-Schichten möglichen Avalanche-Effektes kann die Signalempfindlichkeit zur Intensitätsmessung von y-Strahlen gegenüber dem genannten Wert aber noch um ein Mehrfaches gesteigert werden.

Die a-C:H-Abscheidung kann auch in der Weise erfolgen, daß zunächst - zur Bildung einer defektarmen Carbid-Grenzschicht (Dicke 50 nm) mit einem optischen Bandabstand von 0,9 eV - ein Druck von ca. 20 Pa (Reaktionsgas: CH₄) eingestellt und mit einer HF-Leistungsdichte von 2,5 W/cm² (auf der Kathode) eine DC-Self-bias-Spannung von -900 V erzeugt wird. Nachfolgend wird dann, ohne Zwischenbelüftung, bei einer HF-Leistungsdichte von 0,5 W/cm² (auf der Kathode) bei einem Druck des Reaktionsgases von ca. 200 Pa und einer DC-Self-bias-Spannung von -150 V innerhalb von ca. 18 min eine 3 um dicke a-C:H-Schicht abgeschieden. Diese a-C:H-Schicht weist einen optischen Bandabstand von ca. 2 eV und einen spezifischen elektrischen Widerstand von ca. 10¹⁷ Ω.cm auf.

## Patentansprüche

1. Strahlungsdetektor in Dünnschichttechnik, gekennzeichnet durch zwei plane Metallelektroden, von denen wenigstens eine aus einem Metall mit einer Ordnungszahl Z > 70 besteht, und eine zwischen den beiden Metallelektroden angeordnete Isolierschicht aus plasmaabgeschiedenem amorphem wasserstoffhaltigem Kohlenstoff (a-C:H) mit einem optischen Bandabstand 0,9 eV, die zu der aus einem Metall mit Z > 70 bestehenden Elektrode eine defektarme Grenzschicht mit ohmschen Kontakten bildet.

2. Strahlungsdetektor nach Anspruch 1, dadurch gekennzeichnet, daß die Dicke der Isolierschicht aus a-C:H 0,3 bis 5 um beträgt.

3. Strahlungsdetektor nach Anspruch 1 oder 2, dadurch gekennzeichnet, daß wenigstens eine der beiden Metallelektroden aus einem Schwermetall in Form von Tantal, Wolfram, Rhenium, Osmium, Iridium, Platin oder Gold besteht.

4. Strahlungsdetektor nach Anspruch 3, dadurch gekennzeichnet, daß eine der beiden Elektroden aus einem Schwermetall und die andere aus Aluminium besteht.

5. Strahlungsdetektor nach Anspruch 3 oder 4, dadurch gekennzeichnet, daß die Schwermetallelektrode eine Dicke von 1 bis 5 um aufweist.

6. Strahlungsdetektor nach einem oder mehreren der Ansprüche 1 bis 5, dadurch gekennzeichnet, daß eine der beiden Metallelektroden auf einem Trägermaterial angeordnet ist.

7. Strahlungsdetektor nach Anspruch 6, dadurch gekennzeichnet, daß das Trägermaterial ein Wafer, ein Glassubstrat oder eine Kunststoffolie ist.

8. Strahlungsdetektor nach einem oder mehreren der Ansprüche 1 bis 7, gekennzeichnet durch einen Mehrlagenaufbau, wobei wenigstens zwei Detektormodule aus je einem Paar Metallelektroden und einer Isolierschicht aus a-C:H hinter- oder übereinander angeordnet sind und die einzelnen Detektormodule jeweils durch eine entsprechende Isolierschicht aus a-C:H voneinander getrennt sind.

9. Verfahren zur Herstellung eines Strahlungsdetektors nach einem oder mehreren der Ansprüche 1 bis 8, dadurch gekennzeichnet, daß der amorphe wasserstoffhaltige Kohlenstoff durch eine Hochfrequenz-Niederdruck-Plasmaabscheidung gasförmiger Kohlenwasserstoffe erzeugt wird, und zwar zunächst bei einer Self-bias-Spannung -800 V und dann bei einer Self-bias-Spannung -400 V.

10. Verfahren nach Anspruch 9, dadurch gekennkennzeichnet, daß der amorphe wasserstoffhaltige Kohlenstoff auf einer Schicht aus einem Metall mit einer Ordnungszahl Z > 70 abgeschieden wird.
